(19) Europäisches Patentamt

European Patent Office

Office européen des brevets

(11) **EP 1 482 069 A1**

(12) **EUROPEAN PATENT APPLICATION**

(43) Date of publication:
**01.12.2004 Bulletin 2004/49**

(51) Int Cl.7: **C23C 16/22**, C23C 16/02

(21) Application number: **03447127.6**

(22) Date of filing: **28.05.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(71) Applicant: **INTERUNIVERSITAIR MICROELEKTRONICA CENTRUM VZW**
**3001 Leuven (BE)**

(72) Inventor: **Witvrouw, Ann**
**3020 Herent (BE)**

(74) Representative: **Bird, William Edward et al**
**Bird Goen & Co.,**
**Klein Dalenstraat 42A**
**3020 Winksele (BE)**

(54) **Method for producing polycrystalline silicon germanium suitable for micromachining**

(57) The present invention describes a method of producing a *SiGe* layer on a substrate, said method comprising: depositing onto said substrate a first layer of polycrystalline silicon-germanium ($Si_yGe_{1-y}$) by chemical vapour deposition (CVD) at a temperature T1; and depositing onto said first layer a second layer of polycrystalline silicon-germanium ($Si_zGe_{1-z}$) by plasma enhanced chemical vapour deposition (PECVD) at a temperature T2. The *SiGe* layer is the combination of said first layer and said second layer. The *SiGe* layer is preferably polycrystalline and T1 and T2 are preferably $\leq 520°C$.

MEMS or micro-machined devices may be formed in or on the SiGe layer.

Fig. 2

**Description**

**Field of the invention**

The invention is related to methods to obtain as-deposited, low-stress and low resistivity polycrystalline SiGe layers as well as semiconductor devices utilizing the SiGe layers. For example, these layers can be used in Micro Electro-Mechanical Systems (MEMS) devices or micro-machined structures.

**Background of the invention**

Micro Electro Mechanical Systems (MEMS) are used in a wide variety of systems such as accelerometers, gyroscopes, infrared detectors, micro turbines, etc. For high volume applications, fabrication costs can possibly be reduced by monolithic integration of MEMS with the driving electronics. Also, for 2D imaging applications (e.g. detectors, displays) monolithic integration of MEMS and CMOS processing is a good solution as this simplifies the interconnection issues. The easiest approach for monolithic integration is post-processing MEMS on top of the driving electronics, as this does not introduce any change into standard fabrication processes used for realising the driving electronics. It also allows the realisation of a more compact micro-system. This is not possible if the MEMS-device is produced prior to the formation of the driving electronics. On the other hand, post processing imposes an upper limit on the fabrication temperature of MEMS to avoid any damage or degradation in the performance of the driving electronics. This temperature is typically 450°C. An overview of the several approaches with respect to the integration of driving electronics and MEMS devices can be found in 'Why CMOS-integrated transducers? A review', Microsystem Technologies, Vol. 6 (5), p 192-199, 2000, by A. Witvrouw et al.

For many micromachined devices, such as transducers and other free-standing structures, the mechanical properties of the applied thin films can be critical to their success. For example, stress or stress gradients can cause free-standing thin-film structures to warp to the point that these structures become useless. Such thin film layers have ideally a low stress and a zero stress gradient. If the stress is compressive (minus-sign (-)), structures can buckle. If the stress is too high tensile (plus-sign (+)), structures can break. If the stress gradient is different from zero, microstructures can deform, e.g. cantilevers can bow.

Polycrystalline silicon (poly Si) has been widely used for MEMS applications. The main disadvantage of this material is that it requires high processing temperatures, higher than 800°C, to achieve the desired physical properties especially stress as explained in "Strain studies in LPCVD polysilicon for surface micromachined devices," Sensors and Actuators **A** (physical), **A77** (2), p. 133-8 (1999), by J. Singh S. Chandra et al. This means that poly Si MEMS applications can not be used for integration with CMOS if the CMOS is processed before the MEMS device.

Polycrystalline silicon germanium (poly SiGe) is known in the art as an alternative to poly Si as it has similar properties. The presence of germanium reduces the melting point of the silicon germanium alloy and hence the desired physical properties are expected to be realised at lower temperatures, allowing the growth on low-cost substrates such as glass. Depending on the germanium concentration and the deposition pressure, the transition temperature from amorphous to polycrystalline can be reduced to 450°C, or even lower, compared to 580°C for CVD poly Si.

A functional poly SiGe layer for instance for use in microstructure devices as for instance in gyroscopes, accelerometers, micro-mirrors, resonators, etc. (typically *3* $\mu m$ to *12* $\mu m$ thick) requires low-stress *(< 20MPa* compressive and < 100*MPa* tensile) and low electrical resistivity. An important issue for industrial applicability is moreover that it must be possible to produce these layers with a relative high deposition rate. A reasonably small variance of characteristics between different points on the wafer should be achieved.

WO 01/74708 deals with the development of low-stress poly-SiGe layers under different deposition parameters. Patent application WO 01/74708 is hereby incorporated by reference in its entirety. Some deposition parameters studied are for example deposition temperature, concentration of semiconductors (*e.g.*, the concentration of Silicon and Germanium in a $Si_xGe_{1-x}$ layer, with x being the concentration parameter), concentration of dopants (*e.g.*, the concentration of Boron or Phosphorous), amount of pressure and use of plasma.

Fast deposition methods such as PACVD (Plasma Assisted CVD) or PECVD (Plasma Enhanced CVD) having a typical deposition rate > 100 nm/min, normally result in amorphous layers with high stress and high resistivity at temperatures compatible with CMOS (450°C or lower), for low germanium concentrations. Polycrystalline layers deposited with PECVD with low stress and low resistivity are described in WO 01/74708, but only at high temperatures (above 550°C).

Slow deposition methods such as CVD (with typical deposition rates of about 5-15 nm/min) can give crystalline layers with low resistivity at 450°C, but this is not an economical process in a single wafer tool for, for instance, 10 µm thick layers since the processing time is long. In WO 01/74708 it is indicated that the CVD deposition of in-situ boron doped poly crystalline SiGe at lower temperature (around 400°C) is feasible if the Ge concentration is high enough (above 70%) and if the boron concentration is high enough (above $10^{19}$ /$cm^3$).

## Summary of the invention

The present invention has as an object the development of a deposition process for polycrystalline-SiGe layers and devices therewith while preferably improving stress and/or resistivity and/or speed of deposition.

In one aspect the present invention provides a method of producing a *SiGe* layer on a substrate, said method comprising:

a. depositing onto said substrate a first layer of polycrystalline silicon-germanium $(Si_yGe_{1-y})$ by a chemical vapour deposition technique at a temperature T1 and at a rate of less than 10nm/min; and

b. depositing onto said first layer a second layer of polycrystalline silicon-germanium $(Si_zGe_{1-z})$ by a chemical vapour deposition technique at a temperature T2 and at a rate of at least 50 nm/min, preferably greater than 100nm/min;

said *SiGe* layer being the combination of said first layer and said second layer, wherein said *SiGe* layer is polycrystalline and T1 and T2$\leq$ 520°C. The value of "y" is preferably at least 0.1 (10%).

An embodiment of the above method produces a *SiGe* layer on a substrate, said method comprising:

depositing onto said substrate a first layer of polycrystalline silicon-germanium *$(Si_yGe_{1-y})$ by chemical vapour deposition (CVD) at a temperature T1; and

depositing onto said first layer a second layer of polycrystalline silicon-germanium $(Si_2Ge_{1-z})$ by plasma enhanced or plasma assisted chemical vapour deposition (PECVD or PACVD) at a temperature T2. The *SiGe* layer is the combination of said first layer and said second layer. The *SiGe* layer is preferably polycrystalline and T1 and T2 is preferably $\leq$ 520°C. The value of "y" is preferably at least 0.1 (10%).

An advantage of the above methods is that a polycrystalline SiGe layer may be deposited at CMOS compatible temperatures, e.g. onto a semiconductor device layer which has been manufactured using CMOS processing.

The method can include depositing a nucleation layer onto said substrate before the deposition of said first layer. The nucleation layer may be of silicon or SiGe $(Si_xGe_{1-x})$ deposited at a temperature Tn. Tn is preferably less than or equal to 520°C. The nucleation layer may be amorphous silicon or amorphous SiGe $(Si_xGe_{1-x})$. In a preferred aspect Tn, T1 and T2 are$\leq$ 500°C. For less potential damage to underlying layers of the substrate Tn, T1 and T2 can be $\leq$ 455°C. In a further preferred aspect x is a function of Tn, y is a function of T1 and z is a function of T2.

In the method Tn can = T1 = T2 = T. Under preferred conditions T can be about 450 °C or less. In preferred embodiments $0.50 \leq 1-z \leq 0.70$, alternatively $0.60 \leq 1-z \leq 0.70$.

The PACVD or PECVD can be performed at a pressure between 1 and 10 Torr, for example about 2 Torr. The CVD may be performed at any suitable pressure between low pressure (mTorr) and atmospheric pressure.

The plasma power used for the PECVD or PACVD may be between 10 and 100 W, e.g. about 30W. The plasma power density may be in the range 20-200 mW/cm$^2$.

Preferably the *SiGe* layer has an electrical resistance < 10$m\Omega cm$ , and a stress σ within the compressive to tensile range of: *20MPa* compressive < σ < *100MPa* tensile.

The present invention also provides a semiconductor device comprising a *SiGe* layer on a substrate obtainable by the method described above. In particular it comprises a substrate with a CVD SiGe formed thereon and a PECVD or PACVD SiGe layer formed on the CVD layer. A nucleation layer may be provided between the substrate and the CVD layer. The semiconductor device can further comprise a MEMS or a micro-machined device formed in the *SiGe* layer.

The present invention will now be described with reference to the following drawings.

## Brief Description Of The Drawings

Fig. 1 shows sensor locations on the stressmeter for a 6 inch wafer

Fig. 2 shows a Poly-SiGe layer stack in accordance with an embodiment of the present invention.

Fig. 3 shows variation of average stress with deposition temperature.

Fig. 4 shows variation of average resistivity with deposition temperature.

Fig. 5 shows variation of average resistivity with silane flow rate.

Fig. 6 shows variation of average stress with silane flow rate.

Fig 7: SEM picture of MEMS cantilever constructed in a SiGe layer in accordance with an embodiment of the present invention.

**Description of the invention**

The present invention is described in detail below. It is apparent, however, that a person skilled in the art can imagine several other equivalent embodiments or other ways of executing the present invention, the spirit and scope of the present invention being limited only by the terms of the appended claims.

A polycrystalline SiGe layer is to be deposited on top of a substrate, e.g. a substrate comprising semiconductor material, at a temperature compatible with the underlying material, e.g. the underlying material comprises at least one semiconductor device made by CMOS processing. In embodiments of the present invention, the term "substrate" may include any underlying material or materials that may be used, or contain or upon which a device such as a MEMS device, a mechanical, electronic, electrical, pneumatic, fluidic or semiconductor component or similar, a circuit or an epitaxial layer may be formed. In other alternative embodiments, this "substrate" may include a semiconductor substrate such as e.g. a doped silicon, a gallium arsenide (GaAs), a gallium arsenide phosphide (GaAsP), an indium phosphide (InP), a germanium (Ge), or a silicon germanium (SiGe) substrate. The "substrate" may include for example, an insulating layer such as a $SiO_2$ or an $Si_3N_4$ layer in addition to a semiconductor substrate portion. Thus, the term substrate also includes substrates like silicon-on-glass, silicon-on sapphire substrates. The term "substrate" is thus used to define generally the elements for layers that underlie a layer or portions of interest. Also, the "substrate" may be any other base on which a layer is formed, for example a glass substrate or a glass or metal layer. In the following processing will mainly be described with reference to processing silicon substrates but the skilled person will appreciate that the present invention may be implemented based on other semiconductor material systems and that the skilled person can select suitable materials as equivalents.

The thickness of the SiGe layer can be 0.5-25 $\mu$m, more preferably 8-12 $\mu$m. Other important concerns are maintaining a low or controlled stress or a low or controlled stress gradient and a low or controlled resistivity in the deposited SiGe films, if possible. In accordance with an embodiment of the present invention a polycrystalline SiGe layer is deposited by a combination of Plasma Enhanced Chemical Vapor Deposition (PECVD) or Plasma Assisted Chemical Vapor Deposition (PACVD) and Chemical Vapor Deposition (CVD) processes. The CVD process may be a low pressure up to atmospheric pressure CVD process. The CVD process may be a batch or single wafer process.

The PECVD or PACVD poly-SiGe layers are deposited in a suitable deposition system such as a batch or single wafer system. An example of a suitable system is an Oxford Plasma Technology (OPT) Plasma Lab 100 cold wall system. This consists of two chambers and a central loadlock system. A SiC-covered graphite plate can be used as a carrier for a substrate or semiconductor wafer to avoid contamination at high temperature. The substrate rests on the chuck which is the bottom electrode. The reaction gases are fed into the chamber from the top through the top electrode with integrated shower head gas inlet. A graphite heater heats the chuck to the desired temperature. The calibration for actual wafer temperature can be done in vacuum and at a hydrogen pressure of 2 Torr with a thermocouple wafer, having a number, e.g. seven thermocouples. This system provides the advantage that one system can be used for both low pressure CVD and PECVD. The invention is not limited to the use of a single system and includes use of systems and devices dedicated to one of these processing techniques.

For all SiGe depositions, the gas flows were fixed at a suitable rate, e.g. 166 sccm 10% $GeH_4$ in $H_2$ and 40 sccm 1 % $B_2H_6$ in $H_2$. The $SiH_4$ flow rate is varied and the chamber pressure is maintained at a suitable pressure such as 2 Torr. Films are deposited on (100) Silicon wafers covered with an oxide layer, preferably a thermal oxide layer, e. g. a 250nm thick thermal oxide. 10-100W, e.g. 30W of plasma power may be used for the PECVD deposition. For an electrode diameter of ~ 25 cm the plasma power density equals ~ 60 mW/cm$^2$. A suitable plasma power density range is 20-200 mW/cm$^2$. No plasma power is used for the pure low pressure to atmospheric pressure CVD deposition. The CVD deposition is optionally done on top of a nucleation layer. As a nucleation layer an amorphous seed layer, e.g. a PECVD deposited seed layer, preferably a PECVD deposited amorphous seed layer can be used in order to avoid large incubation times. This seed layer is not strictly necessary when a time budget is not an issue.

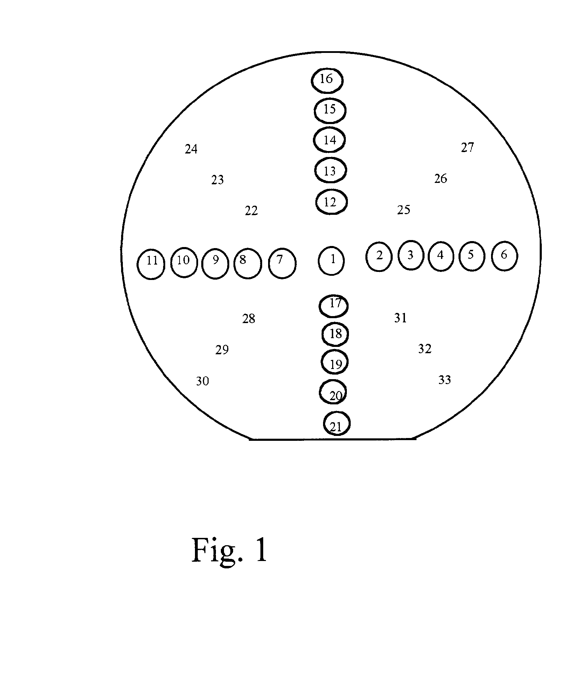

The stress of the SiGe film is measured using a suitable device such as an Eichorn and Hausmann MX 203 stressmeter (Fig.1). It gives the average stress of the film by measuring the bow of the wafer before and after the deposition. The stressmeter has 2x33 sensors, from which 16 local stress values can be measured. For the center stress (Ct), measurements are made on triplets consisting of a center point and two points on the diametrically opposite edges. There are four such triplets on a 6 inch wafer (16-1-21, 24-1-33, 6-1-11, 27-1-30). An average of these values gives the center stress. For the average (Av) stress calculation, triplets are composed of three immediate neighbouring points on a radial line. An average of all such triplets is taken to get the average stress value.

The sheet resistance is measured over the wafer using a suitable probe, e.g. a four point probe. Rutherford Backscattering (RBS) measurements can be carried out to measure Si and Ge concentrations in the film.

Any deposited SiGe layer in accordance with the present invention can be processed by any conventional semiconductor or MEMS processing method. For example, photolithography can be carried out to pattern the as-deposited SiGe layers. For example, the SiGe layer can be etched, e.g. in an STS deep dry etching system, which uses an $SF_6+O_2/C_4F_8$ alternating plasma.

Film thickness is measured using a Dektak surface profiler. Any underlying sacrificial $SiO_2$ can be removed by a vapour HF etch. Below the results of different state-of-the-art methods are described, followed by the results of a method according to the present invention.

### 1. PECVD OR PACVD AT 520°C

The first series of films were deposited at 520°C (Table 1). PECVD was used to take advantage of the higher growth rates. At 520°C, growth rates up to 140 nm/min were observed. These films had very low resistivity values (0.6-1.0 mΩ-cm) and are expected to be polycrystalline.

| Wafer temp. (°C) | $SiH_4$ flow (sccm) | Power [W] | $T_{deposit}$ (min) | Stress (MPa) | Thick [μm] | $Rsheet_a$ [Ω] | ρ [mΩ·cm] | Ge conc. [%] |
|---|---|---|---|---|---|---|---|---|
| 520 | 30 | 30 | 10 | Ct=+13 | 1.0-1.3 | 4.4-6.6 | 0.6-0.7 | 60 |
| 520 | 50 | 30 | 10 | Av=+9 Ct=-8 Av=-12 | 1.1-1.5 | 4.4-6.6 | 0.6-0.8 | 53 |
| 520 | 70 | 30 | 10 | Ct=-26 Av=-37 | 1.3-1.5 | 4.2-7.4 | 0.6-1.0 | 45 |

**Table 1: Measurement results for PECVD films deposited at 520°C**

However, this temperature can be too high for some processes. For CMOS compatibility normally lower temperatures (e.g. at 450°C or lower) are recommended.

### 2. PECVD 450°C

Boron and phosphorous doped PECVD SiGe films were deposited at 450°C. For the P-doped films, unacceptably high resistivity values (>$10^5$ *mΩcm)* were obtained. Similarly, for B-doped films, a very high compressive stress and large resistivity values were obtained, indicating that the films were not polycrystalline but amorphous in nature.

### 3. CVD 450°C

CVD films deposited at 450°C had low resistivity values. But, the long deposition time rules out the possibility of using it for thick films (Table 2).

| Wafer temp. (°C) | SiH₄ flow (sccm) | Power [W] | T$_{deposit}$ Minutes | Stress (MPa) | Thick [μm] | Rsheet$_s$ [Ω] | ρ [mΩ·cm] | Ge conc. [%] |
|---|---|---|---|---|---|---|---|---|
| 450 | 30 | 0 | 120 | Ct=-28 Av=-31 | 1.9-2.5 | 2.7-2.8 | 0.6 | 64 |
| 450 | 50 | 0 | 120 | Ct=-103 Av=-105 | 2.1-2.4 | 3.0-3.5 | 0.7 | 55 |
| 450 | 70 | 0 | 120 | Ct=-167 Av=-160 | 1.8-2.0 | 3.0-4.0 | 0.6-0.7 | 47 |

**Table 2: Measurement results for CVD films deposited at 450°C, using an undoped PECVD amorphous Si nucleation layer.**

### 4. CVD+PECVD FILMS AT 450°C

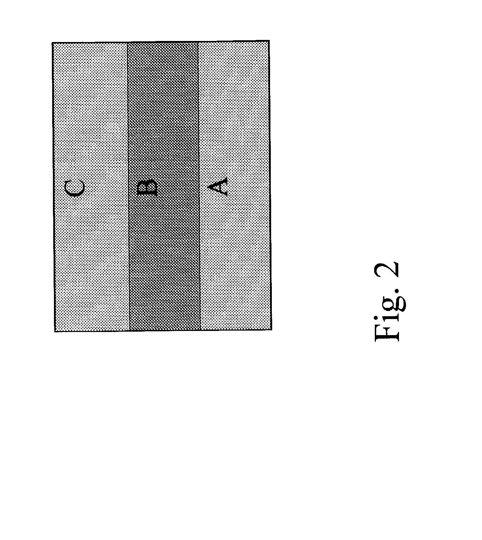

In embodiments of the present invention a combination of both CVD, e.g. low pressure CVD up to atmospheric pressure CVD, and PECVD or PACVD processes is used to obtain polycrystalline films at a low enough temperature (Fig.2). Optionally, a nucleation layer A is deposited, e.g. a thin PECVD or PACVD layer is deposited (A, e.g. ~94nm), to avoid the large incubation time for the growth of SiGe on $SiO_2$ as normally seen in thermal CVD processes. A CVD layer B is deposited on the nucleation layer A. The nucleation layer A is believed to be amorphous and acts as a seed layer for the CVD layer B to be deposited on top (B, e.g. ~370nm). The CVD layer B in its place is a crystallization seed layer for a PECVD or PACVD layer (C, e.g. ~536nm for a total thickness of 1 μm) deposited on top of the CVD layer B, thus making it possible to obtain a polycrystalline film at low temperatures. To reduce processing temperatures it is preferred if the percentage of germanium in the SiGe CVD layer is at least 10%.

Different variations of this process were tried by varying the silane flow rates and deposition temperatures.

A first embodiment of the method for poly-SiGe deposition according to the present invention is described below: a 5 min $H_2$ anneal is followed by a brief PECVD or PACVD deposition at 10-100W, e.g. 30 W plasma power, to form an optional nucleation layer. A suitable plasma power density range is 20-200 mW/cm². The gas flows are fixed at suitable rates, e.g. 166 sccm 10% $GeH_4$ in $H_2$, 40 sccm 1 % $B_2H_6$ in $H_2$. $SiH_4$ flow rate is varied and the chamber pressure is maintained at 2 Torr. Next, a 20 minute CVD step follows to deposit a CVD layer. Finally, a PECVD or PACVD processing step at 10-100W, e.g. 30 W, is carried out to deposit a PECVD or PACVD layer and to obtain the desired thickness. The deposition rate for this step is approximately 113 nm/min. Here the nucleation layer was B-doped SiGe, but any suitable nucleation layer is included within the scope of the present invention. Alternative nucleation layers may be used, e.g. undoped SiGe, or doped Si (preferably, but not only, B-doped), or undoped silicon. Each of the layers, meaning nucleation layer, CVD layer and PECVD or PACVD layer can be differently doped (preferably B or P doped) or undoped. Each layer can have a different doping concentration.

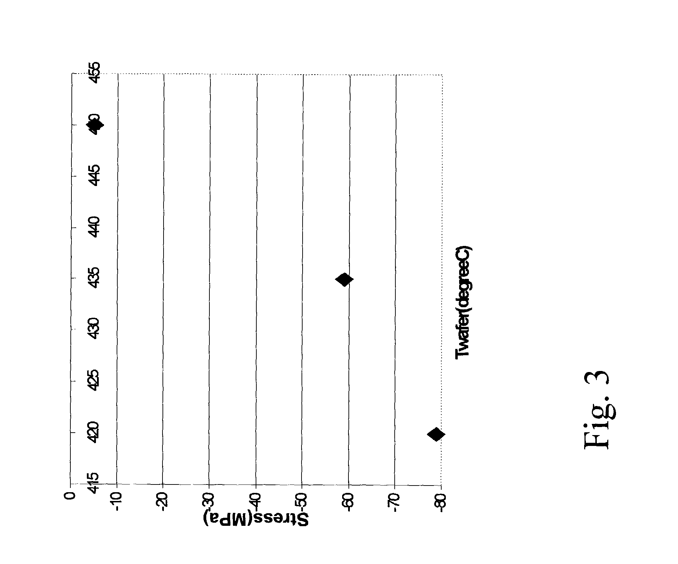

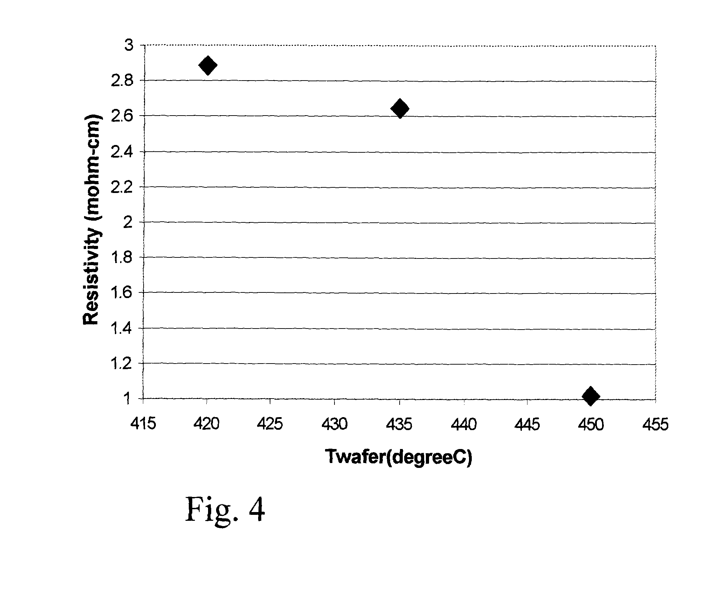

In a first aspect of the first embodiment of the present invention, the method for forming a poly-SiGe layer was performed at 420, 435 and 450°C. It is clear that for the deposition at 450°C a low stress, low resistivity layer is obtained at a reasonable deposition rate *(39nm* /min for a total thickness of 1 μm). This was not possible by the use of PECVD alone. The obtained overall or total deposition rate increases even more for thicker films wherein the fraction $\frac{deposition\ time_{PECVD}}{total\ deposition\ time}$ increases. As can be seen in Table 3, the film becomes more compressive and the resistivity values become higher when the deposition temperature is decreased below 450°C, (Fig. 3 and Fig. 4). It is believed, without being limited by theory, that lowering the temperature reduces the crystallinity of films, which is in accordance with the above observations.

| T_wafer [°C] | SiH_4 [sccm] | Power [W] | Deposition time ' = minutes " = seconds | Thickness [μm] | Stress [Mpa] | R_sheet/sq [ohm] | ρ [mΩ-cm] | Ge conc. [%] |
|---|---|---|---|---|---|---|---|---|
| ~420 | 30 | (30+)0 + 30 | 50" PECVD nucleation+ 20'CVD + 6' PECVD | 0.9-1.0 | Ct= -72 Av= -79 | 14-45 | 1.4-4.0 | 66 |
| ~435 | 30 | (30+)0 + 30 | 50" PECVD nucleation+ 20'CVD + 5'30" PECVD | 0.8-1.0 | Ct= -50 Av= -59 | 13-47 | 1.3-3.8 | 66 |
| ~450 | 30 | (30+)0 + 30 | 50" PECVD nucleation+ 20'CVD + 5' PECVD | 0.9-1.1 | Ct= -0.6 Av= -5 | 7-13 | 0.8-1.2 | 65 |

**Table 3 CVD+PECVD SiGe films at different deposition temperatures**

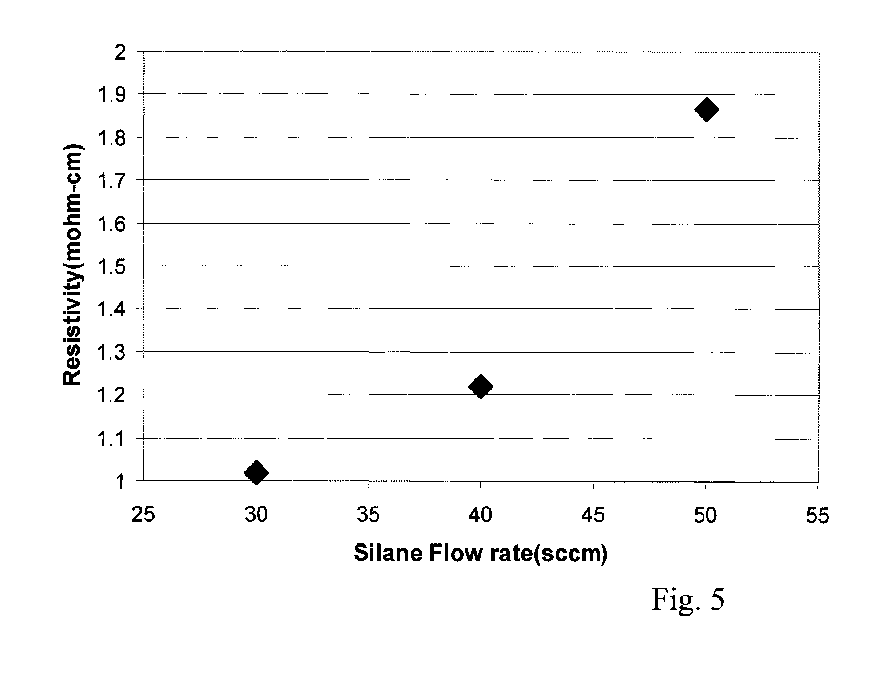

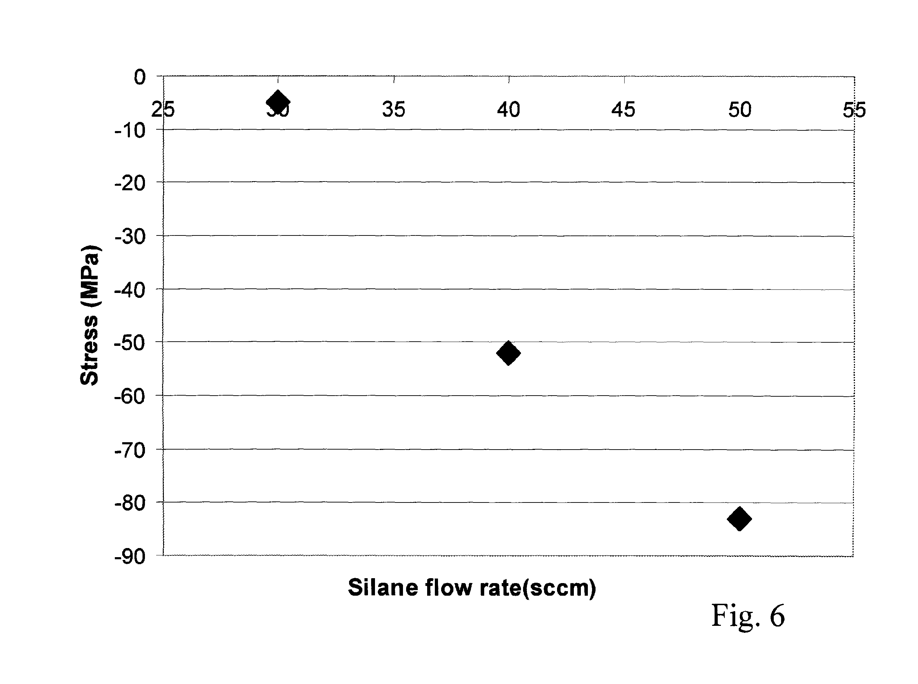

In a second aspect of the first embodiment of the present invention, the method for forming a poly-SiGe layer was performed for differerent silane flow rates (30, 40 and 50 sccm), at a deposition temperature of 450°C (Table 4). As the $GeH_4SiH_4$ ratio increases, the Ge concentration in the film also increases. The RBS data shows a sharp fall in the germanium concentration with the increase in silane concentration. An increase in Ge concentration reduces the amorphous to crystalline transition temperature, thus it is believed that this increase results in more crystalline films at lower temperatures. It is expected that more crystalline films will have lower resistivity values. This can be clearly observed in Fig. 5). Also, the compressive stresses in films increases, as the silane flow increases (see Fig. 6).

| $T_{wafer}$ [°C] | $SiH_4$ [sccm] | Power [W] | Deposition time ' = min "= seconds | Thickness [µm] | Stress [MPa] | $R_{sheets}$ □ [ohm] | ρ [mΩ· cm] | Ge conc. [%] |
|---|---|---|---|---|---|---|---|---|
| ~450 | 30 | (30+) 0 + 30 | 50" PECVD nucleation+ 20' CVD + 5' PECVD | 0.9-1.1 | Ct= -0.6 Av= -5 | 7-13 | 0.8-1.2 | 65 |
| ~450 | 40 | (30+) 0 + 30 | 50" PECVD nucleation+ 20' CVD + 4'48" PECVD | 0.9-1.1 | Ct= -43 Av= -52 | 9-15 | 1.0-1.4 | 60 |
| ~450 | 50 | (30+) 0 + 30 | 50" PECVD nucleation+ 20' CVD + 4'36" PECVD | 0.9-1.1 | Ct= -78 Av= -83 | 11-28 | 1.2-2.5 | 56 |

**Table 4: CVD+PECVD films at silane flow rates of 30, 40 and 50 sccm**

A second embodiment of the present invention, in view of previous optimisations comprises the following steps:

a 1 µm Poly-SiGe film (450°C) can be deposited as follows:

- 5 minutes $H_2$ anneal to ensure temperature uniformity across the wafer.
- 50 seconds PECVD or PACVD flash giving a thin nucleation SiGe layer (~94nm)
- 20 minutes CVD step at 2 Torr with 30 sccm SiH4, 166 sccm 10% $GeH_4$ in $H_2$ and 40 sccm 1 % $B_2H_6$ in $H_2$ to form a CVD layer.
- 5 minutes PECVD OR PACVD with the same gas flows and pressure, and 10-100W, e.g. 30 W plasma power to form a PECVD or PACVD layer.

The film according to the second embodiment of the present invention shows an average compressive stress of -5 MPa and an average resistivity value of *1.0mΩcm.* The RBS data shows a Germanium concentration of 65% in the PECVD or PACVD layer.

Table 5 illustrates the relationship between the overall or total deposition time and the fraction *deposition time$_{PECVD}$ /total deposition time*, whereby

*total deposition time = deposition time$_{nucleation PECVD}$ + deposition time $_{CVD}$ + deposition time $_{PECVD}$* The *deposition time$_{nucleation PECVD}$* and *the deposition time$_{CVD}$* were fixed at 50 seconds and 20 minutes respectively. The obtained overall deposition rate increases for thicker films wherein the fraction $\dfrac{\textit{deposition time}_{PECVD}}{\textit{total deposition time}}$ increases.

The deposition process marked with (*) was performed with a PECVD deposited amorphous silicon layer instead of a PECVD SiGe layer. All films have a low resistivity and a low stress, suitable for surface micromachining.

Tab. 5:

| illustration of the relationship between the fraction *deposition time ${}_{PECVD}$* /*total deposition time* **and the deposition rate.** | | | | | | |
|---|---|---|---|---|---|---|
| PECVD deposition time [min] | Total deposition time ' = min " = seconds | Thickness [µm] | Stress [MPa] | ρ [mΩ-cm] | Ge conc. [%] | Deposition rate {nm/min} |
| 5' | 25' 50" | 0.9-1.1 | Ct= -0.6 Av=-5 | 0.8-1.2 | 65 | 39 |
| 10'(*) | 30' 50" | 1.5-1.7 | Av= +20 | 0.9-1 | Not measured | 53 |
| 84'24" | 105' 14" | 10-13 | Av= +71 | 0.9 | 64 | 109 |

In Table 6 a comparison chart illustrates again the advantages of the present invention.

Table 6:

| Comparison table between state-of-the-art methods (Power=0, 30) and an embodiment of the present invention (power = 0+30). | | | | | | | |
|---|---|---|---|---|---|---|---|
| $T_{wafer(C)}$ | $SH_4$ [scom] | Power[W] | $T_{deposit}$ [min] | Stress [MPa] | Thickness [mm] | r[mWam] | crystal-line? |
| 450 | 30 | 0(CVD) | 120 | AvS=-31 | 1.9-25 | Q6 | yes |
| 450 | 30 | 30(PECVD) | 10 | AvS~-104 | not measured | >10E4 | no |
| 450 | 30 | 0+30 | 20+10 | AvS=+20 | 1.5-1.7 | 091 | yes |

From the above results certain optimised operation conditions are within the scope of the present invention. For example, x can be a function of Tn, y is a function of T1 and z is a function of T2. In the method Tn can = T1 = T2 = T. Under such circumstances T can be about 450 °C. In the method $0.50 \leq 1$-$z \leq 0.70$, alternatively $0.60 \leq 1$-$z \leq 0.70$.

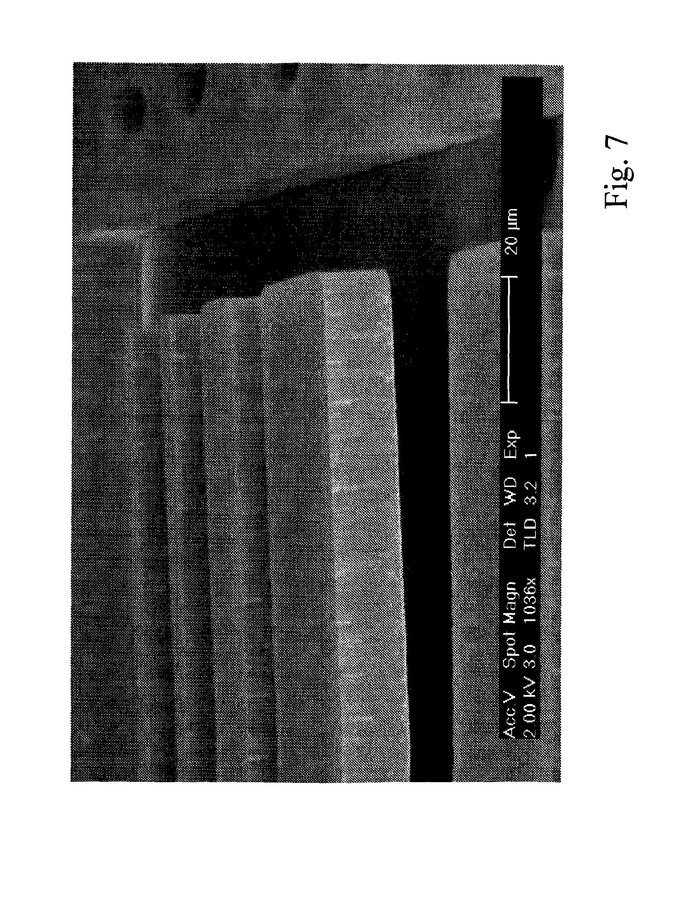

Fig. 7 shows free cantilevers formed in a SiGe layer deposited in accordance with the present invention. Such microstructures can be fomed above layers comprising semiconductor active components, e.g. as formed by CMOS processing.

**Claims**

**1.**  A method of producing a *SiGe* layer on a substrate, said method comprising:

a. depositing onto said substrate a first layer of polycrystalline silicon-germanium *($Si_yGe_{1-y}$)* by chemical vapour deposition (CVD) at a temperature T1; and
b. depositing onto said first layer a second layer of polycrystalline silicon-germanium *($Si_zGe_{1-z}$)* by plasma enhanced chemical vapour deposition (PECVD) or plasma assisted CVD (PACVD) at a temperature T2;

said *SiGe* layer being the combination of said first layer and said second layer, wherein said *SiGe* layer is polycrystalline and T1 and T2 ≤ 520°C.

**2.**  Method according to claim 1, depositing a nucleation layer onto said substrate at a temperature Tn before the deposition of said first layer, Tn being less than or equal to 520°C.

**3.**  Method according to claim 2, wherein the nucleation layer is silicon or SiGe *($Si_xGe_{1-x}$)*.

**4.**  Method according to claim 1, 2 or 3, with Tn, T1 and T2 ≤ 500°C.

**5.**  Method according to any of claims 1 to 4, with Tn, T1 and T2 ≤ 455°C.

**6.** Method according to any of claims 1 to 5, wherein x is a function of Tn, y is a function of T1 and z is a function of T2.

**7.** Method according to any of claims 1 to 6, with Tn = T1 = T2 = T.

**8.** Method according to claim 7, wherein T is about 450 °C.

**9.** Method according to claim 8, wherein $0.50 \leq 1\text{-}z \leq 0.70$.

**10.** Method according to claim 9, wherein $0.60 \leq 1\text{-}z \leq 0.70$.

**11.** Method according to any of claims 1 to 10 performed at a pressure between 1 and 10 Torr.

**12.** Method according to any of claims 1 to 11 wherein said plasma power is between 10 and 100 W.

**13.** Method according to any one of the claims 1 to 12, wherein a plasma power density is in a range 20-200 mW/cm$^2$.

**14.** The method of any of claims 1 to 13, wherein said *SiGe* layer has an electrical resistance < *10mΩcm*.

**15.** The method of any of claims 1 to 14, wherein said *SiGe* layer has a stress σ :whereby *20MPa* compressive stress < σ < 100*MPa* tensile.

**16.** A semiconductor device comprising a *SiGe* layer on a substrate obtainable by the method of any of the claims 1 to 15.

**17.** The semiconductor device according to claim 16, further comprising a MEMS or a micro-machined device formed in the *SiGe* layer.

**18.** A method of producing a *SiGe* layer on a substrate, said method comprising:

a. depositing onto said substrate a first layer of polycrystalline silicon-germanium *(Si$_y$Ge$_{1\text{-}y}$* by a chemical vapour deposition technique at a temperature T1 and at a rate of less than 10nm/min; and
b. depositing onto said first layer a second layer of polycrystalline silicon-germanium *(Si$_z$Ge$_{1\text{-}z}$)* by a chemical vapour deposition technique at a temperature T2 and at a rate of at least 50 nm/min, preferably greater than 100nm/min;

said *SiGe* layer being the combination of said first layer and said second layer, wherein said *SiGe* layer is polycrystalline and T1 and T2 ≤ 520°C.

Fig. 1

Fig. 2

Fig. 3

Fig. 4

EP 1 482 069 A1

Fig. 5

EP 1 482 069 A1

Fig. 6

EP 1 482 069 A1

Fig. 7

European Patent
Office

**PARTIAL EUROPEAN SEARCH REPORT**

which under Rule 45 of the European Patent Convention
shall be considered, for the purposes of subsequent
proceedings, as the European search report

Application Number

EP 03 44 7127

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | WO 01 74708 A (IMEC INTER UNI MICRO ELECTR ;RUSU CRISTINA (BE); BAERT KRIS (BE);) 11 October 2001 (2001-10-11) | 1-12 | C23C16/22 C23C16/02 |
| X | * page 21, line 4 - page 24, line 15 * --- | 16,17 | |
| A | US 6 448 622 B1 (FRANKE ANDREA ET AL) 10 September 2002 (2002-09-10) | 1-12 | |
| X | * the whole document * --- | 16,17 | |
| A | US 2003/071307 A1 (NOGUCHI TAKASHI ET AL) 17 April 2003 (2003-04-17) | 1-12 | |
| X | * the whole document * --- | 16 | |
| A | US 2001/032986 A1 (MIYASAKA MITSUTOSHI) 25 October 2001 (2001-10-25) * page 12, left-hand column, line 25 - line 31 * ----- | 1 | |

**TECHNICAL FIELDS SEARCHED (Int.Cl.7)**

H01L
C23C

### INCOMPLETE SEARCH

The Search Division considers that the present application, or one or more of its claims, does/do not comply with the EPC to such an extent that a meaningful search into the state of the art cannot be carried out, or can only be carried out partially, for these claims.

Claims searched completely :

Claims searched incompletely :

Claims not searched :

Reason for the limitation of the search:

see sheet C

| Place of search | Date of completion of the search | Examiner |
|---|---|---|
| BERLIN | 17 February 2004 | Le Meur, M-A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**European Patent
Office**

**INCOMPLETE SEARCH
SHEET C**

Application Number

EP 03 44 7127

Claim(s) searched completely:
        1-17

Claim(s) searched incompletely:
        18

Reason for the limitation of the search:

Present claim 18 relate to a method defined by reference to a desirable characteristic or property, namely the growth at low temperature (<520°C) and high growth rate (>50nm/min) of a polycrystalline SiGe layer.

The claim cover all methods having this characteristic or property, whereas the application provides support within the meaning of Article 84 EPC and disclosure within the meaning of Article 83 EPC for only a very limited number of such methods. In the present case, the claim so lack support, and the application so lacks disclosure, that a meaningful search over the whole of the claimed scope is impossible. Independent of the above reasoning, the claims also lack clarity (Article 84 EPC). An attempt is made to define the method by reference to a result to be achieved. Again, this lack of clarity in the present case is such as to render a  meaningful search over the whole of the claimed scope impossible. Consequently, the search has been carried out for those parts of the claims which appear to be clear, supported and disclosed, namely a method of growing a polycrystalline SiGe film comprising the growth of a first polycrystalline SiGe layer by CVD (with no plasma) at a growth rate of less than 10 nm/min followed by the growth of another polycrystalline SiGe layer by plasma enhanced CVD at a growth rate of more than 50 nm/min (method corresponding to the combination of claim 1 and claim 18).

## ANNEX TO THE EUROPEAN SEARCH REPORT
## ON EUROPEAN PATENT APPLICATION NO.

EP 03 44 7127

This annex lists the patent family members relating to the patent documents cited in the above-mentioned European search report.
The members are as contained in the European Patent Office EDP file on
The European Patent Office is in no way liable for these particulars which are merely given for the purpose of information.

17-02-2004

| Patent document cited in search report | | Publication date | Patent family member(s) | | Publication date |
|---|---|---|---|---|---|
| WO 0174708 | A | 11-10-2001 | EP | 1269526 A2 | 02-01-2003 |
| | | | WO | 0174708 A2 | 11-10-2001 |
| | | | US | 2003124761 A1 | 03-07-2003 |
| US 6448622 | B1 | 10-09-2002 | US | 6210988 B1 | 03-04-2001 |
| | | | AU | 3346000 A | 01-08-2000 |
| | | | EP | 1173893 A2 | 23-01-2002 |
| | | | JP | 2002534285 T | 15-10-2002 |
| | | | WO | 0042231 A2 | 20-07-2000 |
| US 2003071307 | A1 | 17-04-2003 | US | 6444509 B1 | 03-09-2002 |
| | | | US | 5828084 A | 27-10-1998 |
| | | | JP | 9008319 A | 10-01-1997 |
| US 2001032986 | A1 | 25-10-2001 | US | 2001013607 A1 | 16-08-2001 |
| | | | US | 6017779 A | 25-01-2000 |
| | | | CN | 1129492 A ,B | 21-08-1996 |
| | | | CN | 1245972 A ,B | 01-03-2000 |
| | | | DE | 69531654 D1 | 09-10-2003 |
| | | | EP | 1335419 A2 | 13-08-2003 |
| | | | EP | 0714140 A1 | 29-05-1996 |
| | | | WO | 9534916 A1 | 21-12-1995 |
| | | | US | 5858819 A | 12-01-1999 |
| | | | US | 5834827 A | 10-11-1998 |

EPO FORM P0459